Europäisches Patentamt

European Patent Office

Office européen des brevets

(19)

(11) Numéro de publication : **0 141 999**
**B1**

(12) **FASCICULE DE BREVET EUROPÉEN**

(45) Date de publication du fascicule du brevet :
27.05.87

(51) Int. Cl.⁴ : **C 30 B 11/00**

(21) Numéro de dépôt : **84111751.8**

(22) Date de dépôt : **02.10.84**

(54) **Procédé et dispositif pour élaborer un lingot d'un matériau semi-conducteur polycristallin.**

(30) Priorité : **05.10.83 FR 8315868**

(43) Date de publication de la demande :
**22.05.85 Bulletin 85/21**

(45) Mention de la délivrance du brevet :
**27.05.87 Bulletin 87/22**

(84) Etats contractants désignés :
**BE CH DE FR GB IT LI NL SE**

(56) Documents cités :
**FR-A- 2 255 950**
**US-A- 4 015 657**

(73) Titulaire : **COMPAGNIE GENERALE D'ELECTRICITE**
**Société anonyme dite:**
**54, rue La Boétie**
**F-75382 Paris Cedex 08 (FR)**

(72) Inventeur : **Fally, Jacques**
**4, Allée François Villon**
**F-91400 Orsay (FR)**

(74) Mandataire : **Weinmiller, Jürgen et al**
**Lennéstrasse 9 Postfach 24**
**D-8133 Feldafing (DE)**

Jouve, 18, rue St-Denis, 75001 Paris, France

EP 0 141 999 B1

## Description

La présente invention concerne un procédé et un dispositif pour élaborer un lingot d'un matériau semi-conducteur polycristallin. Le procédé est d'un type comportant

— une étape de chauffage d'un creuset contenant un échantillon dudit matériau semi-conducteur, ce creuset étant disposé dans une chambre calorifugée, le chauffage permettant d'obtenir un bain du matériau fondu à une température constante supérieure au point de fusion dudit matériau,

— une étape de solidification dudit matériau, cette solidification étant obtenue en retirant de l'énergie calorifique au fond du creuset

— et une étape de refroidissement progressif du creuset.

Dans un procédé connu de ce type décrit dans le document US-A-3 898 051, l'énergie calorifique est retirée au fond du creuset à l'aide d'un échangeur thermique à hélium en contact avec la surface extérieure du fond du creuset sur une portion centrale de cette surface.

Ce procédé présente des inconvénients.

En effet, la surface de la portion du fond du creuset en contact avec l'échangeur est nécessairement faible par rapport à la surface totale du fond du creuset pour ne pas nuire à la fusion de l'échantillon. Il en résulte une vitesse de solidification faible, la durée totale de la solidification étant de l'ordre de 15 à 25 heures environ.

De plus, pendant l'étape de solidification, les isothermes du bain de matériau fondu ont sensiblement une forme hémisphérique centrée sur la surface de contact. Lorsque ce matériau est du silicium destiné à la fabrication de photopiles solaires, les lingots obtenus par ce procédé ont une structure polycristalline hémisphérique, ce qui est, en principe, défavorable à l'obtention de bonnes caractéristiques photovoltaïques du matériau.

Par ailleurs, le procédé décrit dans le document précité est assez compliqué et délicat. En effet, l'étape de solidification comporte successivement une première période où on augmente le flux d'hélium ainsi que la puissance de chauffage et une deuxième période où on continue d'augmenter le flux d'hélium en diminuant la puissance de chauffage. Le passage de la première à la deuxième période s'effectue à un moment où le bain est partiellement solidifié.

La présente invention a pour but de pallier ces inconvénients.

Elle a pour objet un procédé pour élaborer un lingot d'un matériau semi-conducteur polycristallin, du type spécifié plus haut, caractérisé en ce que, la chambre calorifugée comprenant une paroi inférieure amovible recouvrant la majeure partie du fond du creuset, on retire l'énergie calorifique au fond du creuset en enlevant ladite paroi inférieure, la puissance dudit chauffage étant maintenue à un niveau constant pendant toute l'étape de solidification, ce niveau étant celui qui permet d'obtenir ladite température constante du bain à la fin de l'étape de chauffage.

La présente invention a aussi pour objet un dispositif pour mettre en œuvre ce procédé, caractérisé en ce qu'il comporte

— un creuset disposé suivant un axe vertical et contenant un échantillon dudit matériau semi-conducteur,

— une chambre calorifugée entourant complètement ledit creuset, cette chambre comprenant une paroi supérieure horizontale, une paroi inférieure horizontale amovible appliquée sur le fond du creuset et recouvrant la majeure partie de sa surface, et une paroi tubulaire verticale appliquée sur la surface latérale du creuset, cette paroi tubulaire comportant un prolongement inférieur horizontal s'avançant vers l'axe vertical pour soutenir les bords du fond du creuset lorsque ladite paroi inférieure est enlevée,

— un support de ladite chambre, capable de surélever le bord inférieur de ladite paroi tubulaire afin de permettre d'enlever ladite paroi inférieure,

— un enroulement électrique entourant la surface latérale du creuset pour le chauffer

— et des moyens supportant ladite paroi inférieure capables d'enlever cette paroi en la déplaçant du haut en bas dudit support.

Une forme particulière de mise en œuvre du procédé selon la présente invention est décrite ci-dessous, à titre d'exemple, en référence aux dessins annexés dans lesquels

La figure 1 représente en coupe axiale un mode de réalisation du dispositif selon l'invention, juste avant l'étape de solidification du procédé selon l'invention

et la figure 2 représente en coupe axiale le même dispositif pendant l'étape de solidification.

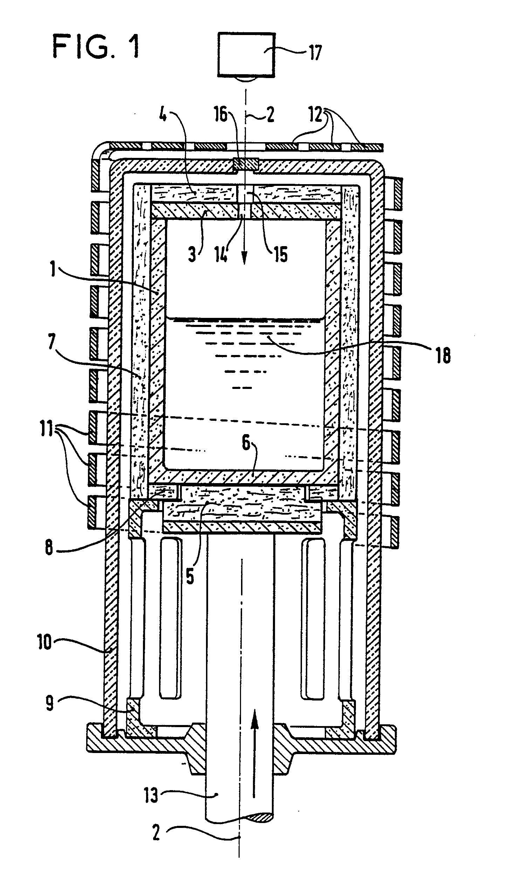

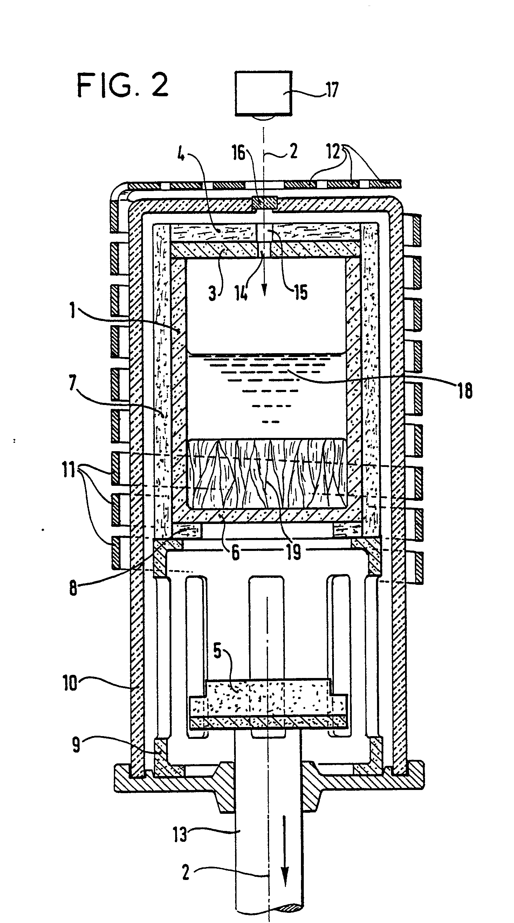

Sur les figures 1 et 2, est représenté un creuset 1 en graphite, disposé verticalement suivant un axe vertical 2. L'ouverture supérieure du creuset 1 est fermée par un couvercle horizontal 3 amovible, également en graphite. Le creuset 1 est placé dans une chambre calorifugée dont les parois, réalisées en feutre de graphite, entourent complètement le creuset et sont appliquées directement sur sa surface extérieure et sur le couvercle. Ces parois comprennent une paroi supérieure horizontale 4 recouvrant le couvercle 3, une paroi inférieure amovible 5 appliquée sur le fond 6 du creuset et recouvrant la majeure partie de la surface de ce fond, et une paroi tubulaire verticale 7 appliquée sur la surface latérale du creuset. La paroi 7 comporte un prolongement inférieur horizontal 8 s'avançant vers l'axe 2, pour soutenir les bords du fond 6 du creuset 1 lorsque la paroi 5 est enlevée. La chambre calorifugée est surélevée par un support 9 en graphite qui repose sur le fond d'une enceinte 10 réalisée en un matériau électriquement isolant, cette enceinte entourant le support 9 et la chambre calorifugée. Autour de l'enceinte est disposé un enroulement électrique qui comporte une partie hélicoïdale 11 entourant la partie supérieure de la surface latérale de l'enceinte 10 et une partie plane 12 disposée au-dessus de la face supérieure de cette enceinte. La paroi inférieure amovible 5 de la chambre calorifugée est fixée sur l'extrémité supérieure d'une tige verticale 13 qui traverse de façon étanche, suivant l'axe 2, le fond de l'enceinte 10. Le couvercle 3 et la paroi 4 comportent respectivement deux petites ouvertures centrales 14 et 15 et la face supérieure de l'enceinte 10 est munie d'une petite fenêtre transparente 16 disposée suivant l'axe 2 en regard des ouvertures 14 et 15. Un pyromètre optique 17 est placé sur l'axe 2 à l'extérieur de l'enceinte 10 devant la fenêtre 16.

Le dispositif décrit ci-dessus permet de mettre en œuvre le procédé selon l'invention de la manière suivante.

On dispose d'abord du silicium solide dans le creuset 1, puis on ferme l'ouverture supérieure du creuset 1 par son couvercle 3 et on place l'ensemble dans la chambre calorifugée. Celle-ci, montée sur son support 9, est disposée dans l'enceinte 10 qui est soigneusement vidée d'oxygène et remplie par exemple d'un gaz inerte tel que l'argon sous faible pression. La paroi inférieure de la chambre calorifugée est mise en place grâce à la tige 13 dont la partie inférieure est reliée à un système de commande non visible sur les figures. Ce système, d'un type connu, est capable de déplacer verticalement la tige 13 suivant l'axe 2. On dispose enfin les enroulements 11 et 12 ainsi que le pyromètre 17.

Les enroulements 11 et 12 sont reliés à une source électrique à moyenne fréquence, non représentée, de façon à induire dans les parois du creuset 1 et dans son couvercle 3 un courant électrique qui dégage suffisamment de chaleur pour faire fondre le silicium placé dans le creuset. La présence d'une atmosphère inerte dans l'enceinte 10 empêche toute combustion du creuset, de son couvercle, du support 9 et du feutre de carbone constituant les parois de la chambre calorifugée. On obtient un bain 18 de silicium fondu et on règle l'alimentation électrique des enroulements 11 et 12 à un niveau permettant de maintenir ce bain à une température constante légèrement supérieure à la température de fusion de silicium. L'ensemble du dispositif est alors conforme à ce qui est représenté sur la figure 1, le creuset 1, le couvercle 3, les enroulements 11 et 12 et la chambre calorifugée constituant un four à induction.

On actionne alors le système de commande de la tige 13 de façon à provoquer un déplacement de haut en bas de cette tige suivant l'axe 2, tout en maintenant la puissance d'alimentation électrique du four au niveau permettant, à la fin de l'étape précédente, de maintenir constante la température du bain à une valeur légèrement supérieure à celle de la fusion du silicium. La paroi 5 de la chambre calorifugée est alors abaissée de façon à occuper la position indiquée sur la figure 2. Le fond du creuset ainsi découvert évacue par rayonnement une partie de son énergie calorifique. Il en résulte une cristallisation du silicium, qui débute au fond du creuset 1 et se propage progressivement vers la surface du bain. Pendant toute cette étape de solidification, la puissance d'alimentation électrique du four reste constante, au même niveau que celui où elle était réglée à la fin de l'étape précédente.

La figure 2 représente le dispositif au cours de l'étape de solidification, alors qu'une masse de silicium solidifié 19 s'est formée dans le bain 18. On voit que la surface de séparation entre le silicium solide et liquide est sensiblement horizontale ; il est possible de vérifier que les isothermes du bain 18 restent horizontales au cours de l'étape de solidification.

Lorsque la masse de silicium est entièrement solidifiée, le réglage de la puissance électrique d'alimentation du four est abaissé progressivement, puis on sépare le lingot du creuset par des méthodes connues.

Exemple

On utilise un creuset à base de graphite ayant une section interne carrée de 500 cm² et une épaisseur de paroi de deux centimètres. La chambre calorifugée comporte des parois en feutre de graphite de deux centimètres d'épaisseur.

On dispose au départ dans le creuset 18 kg de silicium en morceaux de qualité électronique, additionnés d'alliage silicium-bore en quantité suffisante pour obtenir du silicium dopé de type p, d'une résistivité de un ohm-centimètre.

Après la fusion, la température du bain est stabilisée à 1 430 °C. La cristallisation est déclenchée par ouverture d'un orifice de 300 cm² pratiqué dans la partie de la chambre calorifugée qui recouvre le fond du creuset. La durée de cristallisation est de 4 heures environ.

Un lot de cellules solaires a été réalisé en découpant le lingot ainsi obtenu en tranches d'épaisseur 450 µm et de surface 100 cm². Un rendement photovoltaïque de 10,3 % a été mesuré sur une sélection des meilleurs cellules du lot, cette sélection représentant 10 % des cellules.

**Revendications**

1. Procédé pour élaborer un lingot d'un matériau semi-conducteur polycristallin, comportant successivement

— une étape de chauffage d'un creuset contenant un échantillon dudit matériau semi-conducteur, ce creuset étant disposé dans une chambre calorifugée, le chauffage permettant d'obtenir un bain du matériau fondu à une température constante supérieure au point de fusion dudit matériau,

— une étape de solidification dudit matériau, cette solidification étant obtenue en retirant de l'énergie calorifique au fond du creuset

— et une étape de refroidissement progressif du creuset, caractérisée en ce que, la chambre calorifugée comportant une paroi inférieure (5) amovible recouvrant la majeure partie du fond (6) du creuset (1), on retire l'énergie calorifique au fond du creuset en enlevant ladite paroi inférieure, la puissance dudit chauffage étant maintenue à un niveau constant pendant toute l'étape de solidification, ce niveau étant celui qui permet d'obtenir ladite température constante du bain (18) à la fin de l'étape de chauffage.

2. Procédé selon la revendication 1, caractérisé en ce que le matériau semi-conducteur est le silicium.

3. Dispositif pour mettre en œuvre le procédé selon l'une des revendications 1 et 2, caractérisé en ce qu'il comporte

— un creuset (1) disposé suivant un axe vertical (2) et contenant un échantillon dudit matériau semi-conducteur,

— une chambre calorifugée entourant complètement ledit creuset, cette chambre comprenant une paroi supérieure (4) horizontale, une paroi inférieure (5) horizontale amovible appliquée sur le fond (6) du creuset (1) et recouvrant la majeure partie de sa surface, et une paroi tubulaire (7) verticale appliquée sur la surface latérale du creuset, cette paroi tubulaire comportant un prolongement inférieur (8) horizontal s'avançant vers l'axe vertical (2) pour soutenir les bords du fond (6) du creuset lorsque ladite paroi inférieure (5) est enlevée,

— un support (9) de ladite chambre, capable de surélever le bord inférieur de ladite paroi tubulaire (7) afin de permettre d'enlever ladite paroi inférieure (5),

— un enroulement électrique (11) entourant la surface latérale du creuset pour le chauffer

— et des moyens (13) supportant ladite paroi inférieure (5) capables d'enlever cette paroi en la déplaçant du haut en bas dudit support (9).

4 Dispositif selon la revendication 3, caractérisé en ce que le creuset (1) est formé d'un matériau conducteur de l'électricité, ledit enroulement (11) étant apte à induire un courant électrique dans la paroi du creuset lorsqu'il est alimenté par une source électrique alternative.

5 Dispositif selon la revendication 4, caractérisé en ce que le creuset est muni d'un couvercle (3) amovible formé dudit matériau conducteur de l'électricité et que ledit enroulement électrique comporte une partie plane (12) disposée au-dessus du couvercle (3) pour induire dans ce couvercle un courant électrique lorsque cette partie plane est alimentée par ladite source.

6 Dispositif selon la revendication 4, caractérisé en ce que ledit matériau conducteur de l'électricité est du carbone, et que le dispositif comporte en outre une enceinte étanche (10) entourant le creuset (1), cette enceinte étant remplie d'un milieu gazeux protégeant le creuset contre la combustion lorsqu'il est chauffé.

## Claims

1. A method for making an ingot of polycristalline semiconductor material, comprising successively.

— a step of heating a crucible containing a sample of said semiconductor material, this crucible being disposed in a heat-insulated chamber, the heating permitting to obtain a bath of the melted material at a constant temperature which is higher than the melting point of said material,

— a step of solidifying of said material, this solidifying being obtained by removing thermal energy at the bottom of the crucible,

— and a step of gradually cooling the crucible, characterized in that, the heat-insulated chamber comprising a removable lower wall (5) covering the major part of the bottom (6) of the crucible (1), the thermal energy at the bottom of the crucible is removed by withdrawing said lower wall, the heating power being maintained at a constant level during the whole solidification step, this level being that which permits to obtain said constant temperature of the bath (18) at the end of the heating step.

2. A method according to claim 1, characterized in that the semiconductor material is silicon.

3. A device for using the method according to one of claims 1 and 2, characteried in that it comprises

— a crucible (1) disposed along a vertical axis (2) and containing a sample of said semiconductor material,

— a heat-insulated chamber completely surrounding said crucible, this chamber comprising a horizontal upper wall (4), a removable horizontal lower wall (5) applied on the bottom (6) of the crucible (1) and covering most of its surface, and a vertical tubular wall (7) applied on the lateral surface of the crucible, this tubular wall comprising a lower horizontal projection extending towards the vertical axis (2) for supporting the edges of the bottom (6) of the crucible when said lower wall is removed,

— a support (9) of said chamber, capable of raising the lower edge of said tubular wall (7) in order to permit to remove said lower wall (5),

— an electrical coil (11) surrounding the lateral surface of the crucible for heating it,

— and means (13) supporting said lower wall (5) capable of removing said wall by moving it from the top to the bottom of said support (9).

4. A device according to claim 3, characterized in that the crucible is formed of an electrically conductive material, said coil being operable to induce an electric current into the wall of the crucible when it is fed by an alternating current source.

5. A device according to claim 4, characterized in that the crucible is supplied with a removable cover (3) made of said electrically conductive material, and that said electrical coil comprises a plane portion (12) disposed above the cover (3) for inducing an electric current into this cover when this plane portion is fed by said source.

6. A device according to claim 4, characterized in that said electrically conductive material is carbon and in that the device further comprises a tight zone (10) surrounding the crucible (1), this zone being filled with a gaseous medium protecting the crucible against combustion when it is heated.

**Patentansprüche**

1. Verfahren zur Herstellung eines Stabes aus einem polykristallinen Halbleitermaterial, das nacheinander aufweist
— eine Phase des Heizens eines Tiegels, der eine Probe des Halbleitermaterials enthält und der in einer wärmeisolierten Kammer angeordnet ist, wobei das Aufheizen es ermöglicht, ein Bad des geschmolzenen Materials bei einer konstanten Temperatur zu erhalten, die höher als der Schmelzpunkt des Materials ist,
— eine Phase des Erhärtens des Materials, wobei dieses Erhärten dadurch erhalten wird, daß Wärmeenergie am Boden des Tiegels entzogen wird,
— und eine Phase des progressiven Abkühlens des Tiegels, dadurch gekennzeichnet, daß bei Verwendung einer wärmeisolierten Kammer mit einer entfernbaren unteren Wand (5), die den größten Teil des Bodens (6) des Tiegels (1) bedeckt, die Wärmeenergie am Boden des Tiegels dadurch entzogen wird, daß man die untere Wand entfernt, wobei die Heizleistung während der gesamten Erhärtung auf einem konstanten Pegel gehalten wird und dieser Pegel derjenige ist, der es ermöglicht, die konstante Temperatur des Bades (18) am Ende der Heizphase zu erhalten.

2. Verfahren nach Anspruch 1, dadurch gekennzeichnet, daß das Halbleitermaterial Silizium ist.

3. Vorrichtung zur Anwendung des Verfahrens nach einem der Ansprüche 1 und 2, dadurch gekennzeichnet, daß sie aufweist :
— einen Tiegel (1), der entlang einer senkrechten Achse (2) angeordnet ist und eine Probe des Halbleitermaterials enthält,
— eine wärmeisolierte Kammer, die den Tiegel ganz umgibt, wobei diese Kammer eine obere waagerechte Wand (4), eine untere waagerechte, entfernbare Wand (5), die am Boden (6) des Tiegels (1) anliegt und den größten Teil seiner Bodenfläche bedeckt, und eine rohrförmige senkrechte Wand (7) aufweist, die an der Seitenwand des Tiegels anliegt und eine untere waagerechte Verlängerung (8) aufweist, die zur senkrechten Achse (2) hin vorsteht, um die Ränder des Bodens (6) des Tiegels zu halten, wenn die untere Wand (5) entfernt ist,
— einen Träger (9) für die Kammer, der den unteren Rand der rohrförmigen Wand (7) heben kann, um das Entfernen der unteren Wand (5) zu ermöglichen,
— eine elektrische Wicklung (11), die die seitliche Oberfläche des Tiegels umgibt, um ihn aufzuheizen,
— und Mittel (13), die die untere Wand (5) tragen und diese Wand entfernen können, indem sie sie von oben nach unten im Träger (9) bewegen.

4. Vorrichtung nach Anspruch 3, dadurch gekennzeichnet, daß der Tiegel (1) aus einem elektrisch leitenden Material besteht, wobei die Wicklung (11) einen elektrischen Strom in die Wand des Tiegels induzieren kann, wenn sie von einer elektrischen Wechselstromquelle gespeist wird.

5. Vorrichtung nach Anspruch 4, dadurch gekennzeichnet, daß der Tiegel mit einem aus dem elektrisch leitenden Material bestehenden entfernbaren Deckel (3) versehen ist, und daß die elektrische Wicklung einen ebenen Bereich (12) aufweist, der oberhalb des Deckels (3) angeordnet ist, um in diesen Deckel einen elektrischen Strom zu induzieren, wenn dieser ebene Bereich von der Quelle gespeist wird.

6. Vorrichtung nach Anspruch 4, dadurch gekennzeichnet, daß das elektrisch leitenden Material Kohlenstoff ist und daß die Vorrichtung weiter einen dichten Behälter (10) aufweist, der den Tiegel (1) umgibt und mit einem gasförmigen Milieu gefüllt ist, das den Tiegel vor der Oxidation schützt, wenn er erhitzt wird.

FIG. 1

0 141 999

# FIG. 2